(19) Europäisches Patentamt
European Patent Office
Office européen des brevets

(11) **EP 1 177 621 B1**

(12) **EUROPEAN PATENT SPECIFICATION**

(45) Date of publication and mention
of the grant of the patent:
**13.08.2003 Bulletin 2003/33**

(51) Int Cl.⁷: **H03G 1/00**

(86) International application number:
**PCT/US00/09842**

(21) Application number: **00925949.0**

(22) Date of filing: **12.04.2000**

(87) International publication number:
**WO 00/062419 (19.10.2000 Gazette 2000/42)**

(54) **MOS VARIABLE GAIN AMPLIFIER**

MOS-VERSTÄRKER MIT VARIABLER VERSTÄRKUNG

AMPLIFICATEUR A GAIN VARIABLE MOS A FAIBLE BRUIT A HAUTE LINEARITE A GRANDE
ETENDUE DE GAIN

(84) Designated Contracting States:
**AT BE CH CY DE DK ES FI FR GB GR IE IT LI LU
MC NL PT SE**

(30) Priority: **13.04.1999 US 129133 P
12.11.1999 US 439101
14.01.2000 US 483551
28.01.2000 US 493942**

(43) Date of publication of application:
**06.02.2002 Bulletin 2002/06**

(60) Divisional application:
**03013175.9**

(73) Proprietor: **Broadcom Corporation
Irvine, CA 92618-3616 (US)**

(72) Inventor: **BEHZAD, Arya, R.
Irvine, CA 92618-3616 (US)**

(74) Representative:
**Jehle, Volker Armin, Dipl.-Ing. et al
Patentanwälte
Bosch, Graf von Stosch, Jehle,
Flüggenstrasse 13
80639 München (DE)**

(56) References cited:
**EP-A- 0 365 085        WO-A-97/32393
US-A- 5 587 688**

**Description**

BACKGROUND OF THE INVENTION

Radio receivers, or tuners, are widely used in applications requiring the reception of electromagnetic energy. Applications can include broadcast receivers such as radio and television, set top boxes for cable television, receivers in local area networks, test and measurement equipment, radar receivers, air traffic control receivers, and microwave communication links among others. Transmission of the electromagnetic energy may be over a transmission line or by electromagnetic radio waves.

The design of a receiver is one of the most complex design tasks in electrical engineering. In the current state of the art, there are many design criteria that must be considered to produce a working radio receiver. Tradeoffs in the design's performance are often utilized to achieve a given objective. There are a multitude of performance characteristics that must be considered in designing the receiver.

However, certain performance characteristics are common to all receivers. Distortion and noise are two such parameters. The process of capturing the signal creates distortion that must be accounted for in the design of the radio receiver. The distortion must either be filtered out or canceled. Once a radio signal is captured, the noise surrounding the received signal in the receiver must be considered. Radio signals are often extremely weak and if noise is present in the circuit, the signal, even though satisfactorily received, can be easily lost in this noise floor. The current state of the art in receiver design is often directed to overcoming these receiver limitations in a cost effective manner.

In an integrated radio receiver ESD discharge circuitry is typically utilized to protect the integrated circuit from static discharge. Radio signals in a receiver tend to be of small amplitude and high frequency and are therefore susceptible to distortion caused by capacitive loading by standard ESD control methods. It is therefore desirable to provide a system of ESD protection that does not interfere with the reception of the high frequency, small amplitude signals.

Inductors are utilized in a receiver to provide frequency selectivity that helps eliminate distortion and interference. Inductors are not easily integrated onto a semiconductor substrate. Spiral inductors typically used have a low Q that provides insufficient selectivity, requiring filters to be fabricated off of the integrated circuit substrate.

Amplifiers are utilized to boost signal levels above the receiver noise floor. Amplification is used in many receiver functions. It is used in a fixed gain amplifier to provide a fixed gain to a signal presented to it. In providing a fixed gain a signal of a given power level presented to an amplifier is increased in power by a fixed multiplication factor. In a variable gain amplifier ("VGA") gain is often adjusted to provide an output signal of fixed power for a variety of input signal power levels. The multiplication factor is adjusted by a control depending on the power of the input signal.

Amplification is often used in conjunction with other circuit functions. Filters often incorporate amplification to boost a desired signal's level while simultaneously rejecting unwanted signals. Attenuators also incorporate amplifiers to expand their dynamic range. Thus an attenuator with gain included can produce an output signal having more or less power than a signal input to the device, depending on the setting.

Due to inherent amplifier nonlinearities the amplifiers produce distortion. Distortion tends to vary with the signal level presented to an amplifier. Strong input signals tend to increase distortion levels. Often to limit distortion the dynamic range of an amplifier is constrained to. a narrow range of input signal levels to prevent distortion from arising. Constraint on signal level affects a receiver system's overall performance.

For example constraint on input levels requires tight automatic gain control ("AGC") of the receiver giving rise to further problems of stability, response time, and maintenance of the required signal level range. Amplifiers with an increased dynamic range are thus desirable in designing receivers to decrease distortion and to relax systems requirements.

EP-A-0365085 discloses a circuit arrangement for adjusting the amplitude of a signal, the circuit including two differential transistor amplifiers, one of which is arranged to receive the signal via its main-current-path input and the other amplifier is arranged to receive a direct current supply corresponding to the D.C. component of the signal.

According to the present invention there is provided an integrated MOS VGA having improved dynamic range comprising:

a first differential pair amplifier disposed upon the substrate and coupled to a VGA output having a gain contributing to VGA gain in direct proportion to the first differential pair amplifier gain;
a second differential pair amplifier disposed upon the substrate and coupled to the VGA output having a gain, and coupled to the first differential amplifier such that an increase in second differential pair amplifier gain contributes in inverse proportion to the VGA gain; and characterised by
a substrate on which the first and second differential pair amplifiers are disposed; and
a fixed control current split between the first differential pair amplifier and the second differential pair amplifier such that current to the second differential pair amplifier source connection is not greater than current applied to the first differential pair amplifier source connection and applied such that an increase in current causes an increase in amplifier gain.

These and other features and advantages of the present invention will be better understood from the following detailed description read in light of the accompanying drawings, wherein

FIG. 1 is a block diagram of a variable gain amplifier ("VGA");
FIG. 2, is a block diagram of the internal configuration of the VGA and the linearization circuit;
FIG. 3 is a graph of gain versus the control current iSig. Control current iSig is shown as a fraction of jAtten, with the total current being equal to 1, or 100%;
FIG. 4 is the schematic diagram of an embodiment of the VGA. The VGA has a control circuit to control the $V_{ds}$ of M10 and M13 at node 7505, and the $V_{ds}$ ofM4 and M14 at node 7507;
FIG. 5a illustrates a family of curves showing the relationship of a transistor's drain current ("$I_d$") to its gate source voltage ("$V_{gs}$") measured at each of a series of drain source voltages ("$V_{ds}$") from 50 mV to 1 V;
FIG. 5b is a graph of $g_m$, verses $V_{gs}$ as $V_{ds}$ is varied from 50 mV to 1 V;
FIG. 5c is a graph of the cross-section of FIG. 5b plotting $g_m$ verses $V_{ds}$, for various values of $V_{gs}$;
FIG. 6 is a schematic of a current steering circuit;
FIG. 7 is a schematic of a VD1 control signal generation circuit; and
FIG. 8 is a block diagram of a communications network utilizing a receiver according to any one of the exemplary embodiments of the invention.

The present embodiments of the invention allow all channel selectivity and image rejection to be implemented on an integrated circuit. Integration is a achievable by utilizing differential signal transmission, a low phase noise oscillator, integrated low Q filters, filter tuning, frequency planning, local oscillator generation and PLL tuning to achieve a previously unrealized level of receiver integration.

The embodiments of the invention advantageously allow a LC filters to be integrated on a receiver chip, resulting in an integrated circuit that contains substantially the entire receiver. By advantageously selecting a frequency plan, and utilizing the properties of complex mixers, an architecture is achieved that allows LC filters to be integrated on a receiver chip so that acceptable performance is produced when converting a received signal to one having a lower frequency that is easily processed.

The embodiments utilize particular aspects of an arbitrarily defined input spectrum to first shift the received frequencies to a higher frequency in order that interference may be more easily eliminated by filtering and then shifting the spectrum to a nominal IF for processing. This first shifting process advantageously shifts interfering image signals away from a centre frequency of a first LC filter bank so that the LO filter bank is more effective in reducing the interfering signal strength. To further reduce the interfering signal strength, multiple LC filters that are tuned to the same frequency are cascaded, further reducing the interfering signal strength.

To reduce degradation of the desired signal the exemplary embodiments of the invention utilize a complex mixing stage following an LC filter bank to reduce the image frequency interference by an additional amount that might be necessary to meet a particular image rejection target (i.e., an about 60 dB to 65 dB rejection target). A complex mixer creates a signal as a result of its normal operation that cancels an image frequency interference by the remaining amount needed to achieve satisfactory performance with LC filters.

The ultimate goal of a receiver is to reduce the frequency of an incoming signal to a frequency that is lower than received, so that processing of the desired signal can be easily achieved. The receiver architecture utilizes two frequency down conversions to achieve this goal. Each frequency conversion is susceptible to interference that requires filtering. Frequency planning as described above used in conjunction with LC filters and complex mixers, provides the required image distortion rejection that allows LC filters to be used advantageously in an integrated receiver.

Radio receivers require one or more local oscillator (LO) signals in order to accomplish frequency conversion to an intermediate (IF) frequency. In a typical receiver these local oscillator signals must be stable and free from noise. When a receiver is fabricated as an integrated circuit, the chances of injecting noise via the LO signals increases. Local oscillator signals for a receiver are typically generated in close proximity to the frequency conversion circuitry. The close proximity of this frequency generation circuitry to the signal path creates an increased likelihood of noise being radiated or conducted to cause interference with the received signal.

In order to achieve improved noise immunity the exemplary embodiments of the invention may utilize circuitry to generate the local oscillator signals that possess superior noise performance. The local oscillator signals may also be advantageously transmitted-differentially to the mixers present on the integrated circuit. It should be noted that in alternate embodiments of the invention that a single ended output can be produced from the differential signal by various techniques known in the art. This technique is used advantageously whenever external connections to the receiver are required that are single ended.

An exemplary embodiment of the present invention utilizes a differential oscillator having low phase noise or jitter and high isolation, as a frequency reference that substantially increases the performance of a tuner architecture integrated onto a single silicon substrate.

In accordance with the present invention, a crystal oscillator circuit is provided and constructed so as to define a periodic, sinusoidal, balanced differential signal across two symmetrical terminals of a crystal resonator which are coupled in a-parallel configuration across symmetrical, differential terminals of a differential oscillator circuit.

The differential oscillator circuit is configured such that it is constructed of simple active and passive components which are easily implemented in modern integrated circuit technology, thus allowing the differential oscillator circuit to be accommodated on a monolithic integrated circuit chip for which the crystal oscillator (as a whole) is providing a suitable, stable periodic timing reference signal. Similarly, and in contrast to prior art implementations, only the resonating crystal (crystal resonator or quartz crystal resonator) is provided as an off-chip component. This particular configuration allows for considerable savings in component parts costs by partitioning more and more functionality into the integrated circuit chip.

Remote (off chip) mounting of the crystal resonator requires that electrical contact between the crystal resonator and the associated oscillator circuit, be made with interconnecting leads of finite length. In integrated circuit technology, these interconnecting leads are typically implemented as circuit pads and conductive wires formed on a PC board substrate to which package leads are bonded (soldered) in order to effect electrical connection between the crystal resonator and an associated oscillator circuit. External electrical connections of this type are well known as being susceptible to noise and other forms of interference that might be radiated onto the interconnecting leads and, thence, into the oscillator circuit, degrading its overall noise performance.

Advantageously, the present invention contemplates differential signal transmission throughout its architecture to maintain the purity of the derived periodic signal and to minimize any common mode interference components injected into the system. In particular, the present invention incorporates differential signal transmission in the construction of a differential crystal oscillator circuit, including a crystal resonator and its associated oscillator driver circuit. Differential signal transmission is maintained through at least a first linear buffer stage which functions to isolate the differential oscillator circuit switch transients and other forms of noise that might be generated by follow-on digital integrated circuit components.

The VGA and PGA/LNA have characteristics in common that allow interchangeability in alternative embodiments.

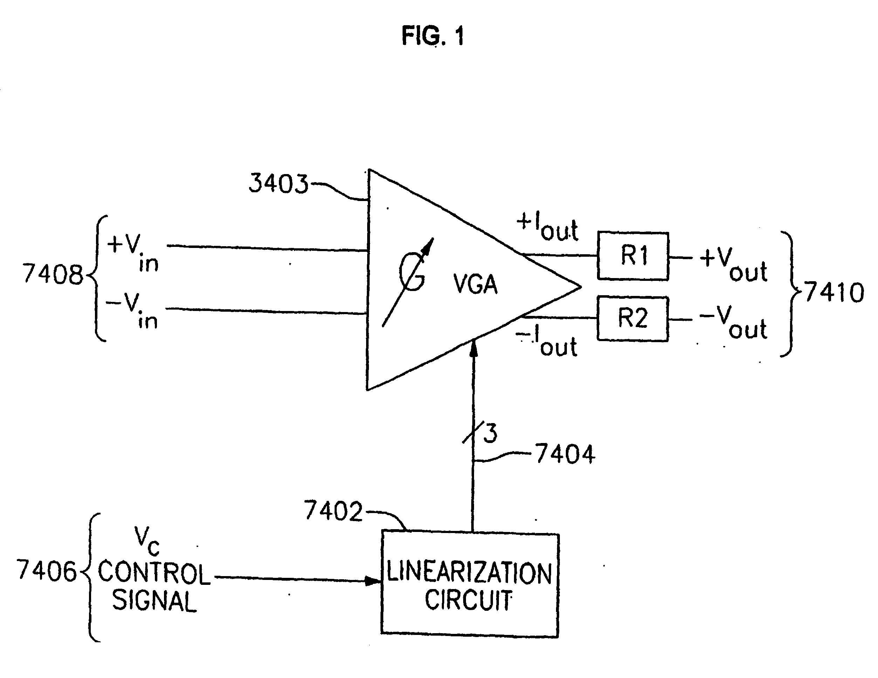

FIG. 1 is a block diagram of a variable gain amplifier ("VGA") 3403. The VGA produces a signal that is a reproduction of a signal input to it at an amplified level. The amplified level in a VGA is capable of being varied. A variable gain is accomplished through the use of one or more control signals applied to the amplifier.

VGAs are frequently used to maintain a constant output signal level. VGAs do this by varying the amplifier gain to compensate for varying input levels. In the case of strong or weak signals it is desirable to maintain a linear gain for input verses output signals with little noise added. Maintenance of a linear gain reduces distortion for high level input signals. VGAs are often used in IF or RF strips to compensate for prior losses or weak signal reception.

In a linear gain, a 1 dB increase in sinusoidal input signal level produces a 1 dB change in the output signal level at that same frequency. A gain of this nature is termed a "linear response." If a 1 dB change is not produced, this is indicative of an available power being diverted to produce a signal at another frequency of operation. A signal at a frequency other than desired often interferes with the signal being amplified and is termed distortion. Thus, the linearity of an amplifier is a figure of merit, the greater the linearity the better the quality ofthe amplifier. Amplifiers that utilize compensation circuitry and differential signal transmission tend to have improved linearity.

VGA compensation circuitry controls $V_{ds}$. For a large input signal, linearity and low gain is required. With a reduction in $V_{ds}$, good linearity and low gain are achieved. If a small signal is input to the amplifier, $V_{ds}$ is increased. The increase in $V_{ds}$ causes one or more MOSFETs internal to the VGA to be biased in the active region. Active region bias allows for high gain and low noise to be achieved simultaneously. The VGA utilizes a current steering method of applying control signals to provide an extended gain range VGA. The control of $V_{ds}$ allows the production of a linear output when a large signal is applied to the input.

The VGA has a differential input comprising two signals, $+V_{in}$ and $-V_{out}$ 7408. The VGA has a differential current output comprising two signals, $+I_{out}$ and $-I_{out}$. In the embodiment shown the differential current signals are applied to a first and second resistor R1 and R2 to produce a differential voltage output, $+V_{out}$ and $-V_{out}$ 7410 respectively. Equivalently the current outputs may be applied to work against any impedance to generate a voltage output.

A set of three control signals 7404 are supplied to the VGA 3403 from a linearization circuit 7402. The linearization circuit 7402 produces the three control signals 7404 that are derived from a single control signal, $V_c$ 7406 through compensation circuitry. Control signal $V_c$ tends to be proportional to the gain desired in the VGA 3403. The three control signals 7404 control the VGA in a manner such that a desired gain and a desired linearity tend to be produced by the VGA.

The linearization circuit is stimulated by the control signal $V_c$ 7406 is supplied by an external DSP chip. The control signal applied to the linearization circuit 7402 is shaped in a predetermined way. A goal of shaping the control circuit is to produce the second set of control signals 7404 that are applied to the VGA 3403 to produce a desired VGA gain transfer function, measured in decibels, that changes linearly with the applied control signal $V_c$. In the embodiment shown $V_c$ is a voltage, however a control circuit may be equivalently supplied. In an alternate embodiment the overall transfer function of the VGA is configured to yield a linear function of gain as measured with linear units versus control voltage by appropriately adjusting the linearization circuit through the application of a log to linear conversion current.

In addition to shaping the gain transfer function, another function ofthe linearization circuit is to control signals that control the VGA to produce the desired low distortion output. The second set of control signals 7404 are shown as a bussed line 7404. The second set of control signals comprise a voltage VD1, and a pair of control currents: iSig and iAtten. The second set of control signals 7404 tend to produce a linear change in gain with variation of the control signal while maintaining an acceptable distortion level in the VGA.

The three control signals are generated by two subcircuits in the linearization circuit: a current steering circuit and a drain voltage control voltage signal generation circuit. The current steering circuit produces two signals, iSig and iAtten. The drain voltage control signal voltage generation circuit produces one signal, VD1.

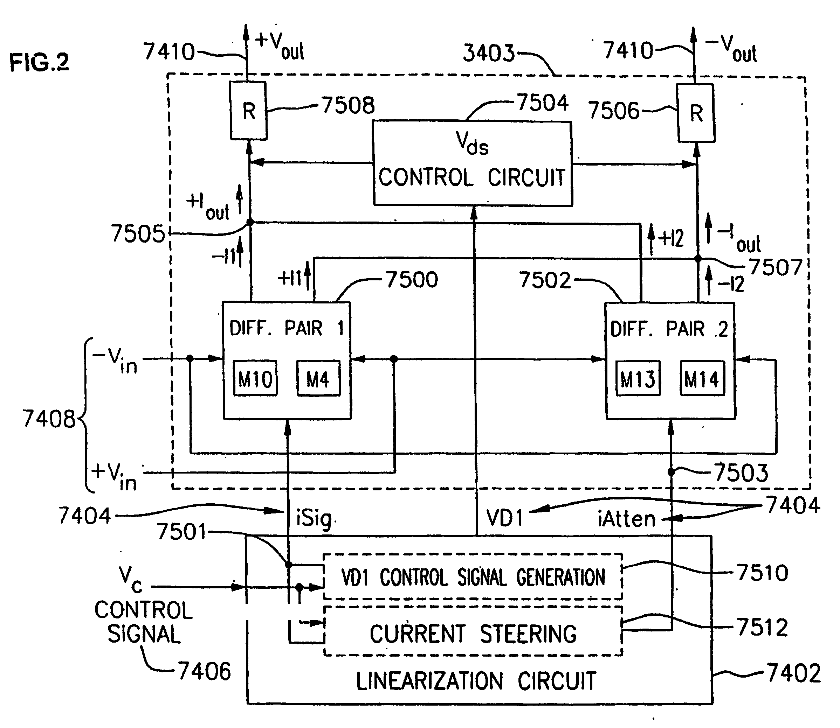

FIG. 2, is a block diagram of the internal configuration of the VGA and the linearization circuit. The VGA and linearization circuit to implement current steering and $V_{(13}$ control ofthe VGA are described as a separate function block. However, the functions described may be equivalently merged into the circuit functional blocks of the other.

The VGA 3403 is constructed from two cross coupled differential pair amplifiers 7500 7502. A first differential pair amplifier 7500 includes two transistors M4 and Mb. A second differential pair amplifier 7502 includes transistors M13 and M14. The first and second differential pair amplifiers are driven in parallel by a differential input voltage 7408. When referenced to ground, the differential input voltage applied to each amplifier simultaneously is denoted $+V_{in}$ and $-V_{in}$.

The differential pair amplifiers have differential current outputs +I1, -I1, +I2, -I2, that are combined to produce a differential VGA output comprising $+I_{out}$ and $-I_{out}$. The first differential pair amplifier 7500 has differential current outputs +I1 and -I1 that are sinusoidal and 180 degrees out of phase from each other. The second differential pair amplifier 7502 has differential current outputs +I2 and -I2 that are sinusoidal and 180 degrees out of phase from each other. VGA output current $+I_{out}$ results from the combination at node 7505 of out of phase currents -I1 and +I2. VGA output current $-I_{out}$ results from the combination at node 7507 of out of phase currents +I1 and -I2. Note that the currents described above having a minus sign prefix, -I1, -I2, ate generated in response to input voltage $-V_{in}$ and the currents with plus sign prefixes, +I1, +I2, are generated in response to $+V_{in}$.

A $V_{ds}$ control circuit 7504 within the VGA 3403 supplies a $V_{ds}$, control voltage that is applied to nodes 7505 and 7508. The $V_{ds}$ control circuit receives an input VD1 from a VD1 control signal generation circuit 7510 that is a part of the linearization circuit 7402. In alternative embodiments the $V_{ds}$ control circuit is merged into the VD 1 control signal generation circuit 751.

A current steering circuit 7512 in the gain control circuit 7402 supplies control signals iSig and iAtten. The signal iSig is a control input to the first differential pair amplifier 7500. The signal iAtten is a control input to the second differential pair amplifier 7500.

In the embodiment shown the VGA 3403 is configured to operate at an IF frequency. However it is understood that the VGA may be configured, by appropriate component selection to function at any desired frequency. In an IF strip, the addition of a VGA maintains a constant IF output as the input varies. This is accomplished by adjusting the gain of the VGA. A VGA is useful in any situation where a signal presented to a circuit is of unknown or variable strength.

Functionally the VGA maintains a constant level at its output so that subsequent circuitry may be designed that tends to have better performance and less noise. In alternate embodiments, the variable gain amplifier may be used at RF or other frequencies to reduce signal level variations in a circuit. For example in an embodiment, a VGA 3403 as described may be used in the RF front end 3408 to control the RF signal level that is applied to a receiver 3402.

The overall gain of the VGA is attributable to the individual gain contributions of transistors M1O M4, M13 and M14 that produce a current gain. In an embodiment, the VGA voltage gain is set by providing resistance at the $+I_{out}$ and $-I_{out}$ terminals to establish a voltage output, and thus a voltage gain for the amplifier. The exemplary embodiment includes field effect transistors ("MOSFETS"). Equivalently, other transistor types may be substituted for the MOSFETs utilized in the exemplary embodiment. A pair of control currents iSig and iAtten and a control voltage VD1 are principally used to provide an extended range of available VGA gain and a linear in dB VGA amplifier transfer function that provides a desired linearity.

Two methods of gain control are utilized in the exemplary VGA. The first method is $V_{ds}$ control that controls noise and linearity while reducing VGA gain when large signals are applied, the second is current steering that provides an extended range of available VGA gain. The set of three control signals 7404 include iSig, iAtten and VD1.

In the first method of $V_{ds}$ control, gain and linearity in the output of the VGA tend to be controlled by adjusting each of four transistors M4, M10, M13, M14 drain source voltages ("$V_{ds}$") of the transistors to control a transductance ("$g_m$") associated with each transistor. If a drain source voltage $V_{ds}$, across a MOSFET device M10, M4, M13, M14 is reduced, a $g_m$ transfer characteristic of that transistor, which is a function of input voltage, becomes flatter. The flatter

the $g_m$ transfer function the more linearly the transistor tends to operates. The $V_{ds}$, of all four transistors is controlled in order to manipulate an overall $g_m$ characteristic for the VGA.

The $V_{ds}$ gain control method tends to reduce VGA output distortion by tending to improve the linearity of the VGA. To improve the linearity, the $V_{ds}$ of the transistors are reduced yielding better linearity in conjunction with a transistor operating point on a flattened $g_m$, curve. As an input signal's strength increases, $V_{ds}$, is reduced providing a linear response VGA. Reducing $V_{ds}$ also tends to contribute to VGA gain control. For small input signals as $V_{ds}$ is increased the MOSFETs become biased in the active region where high gain and low noise operation is obtained. The main effect of reducing $V_{ds}$ tends to be control of the linearity of the VGA amplifier.

In the second method, current steering control, currents iSig and jAtten tend to set amplifier gain over a large range. An increase in the control current iSig tends to increase gain by causing an increase in overall amplifier $g_m$, while an increase in iAtten tends to decrease gain by causing a subtraction of overall amplifier $g_m$. For certain type and size MOSFETs, the relationship between iSig, iAtten and $g_m$, is as shown in equation (1)

$$g_m = \sqrt{\frac{K}{2}}\left(\sqrt{iSig} - \sqrt{iAtten}\right) \qquad (1)$$

where

iAtten = $I_{tot}$ - $I_{sig}$

K = a constant of proportionality

For other size/type transistors this relationship may not hold, but the idea is still applicable. The $g_m$s of each transistor M10, M4, M13, M14 is controlled to adjust gain. This is accomplished by subtracting, or adding currents through control lines. iSig and iAtten to boost or reduce the VGA $g_m$, as required. Control signals iSig and iAtten control amplifier gain by adjusting an overall $g_m$ ofthe amplifier. A fixed available control current is available for controlling VGA gain through the iSig and iAtten control lines. Gain is controlled by selectively steering the available current into the appropriate control line. For large VGA signal inputs, the linearity produced in a VGA from current steering tends to be improved by the addition of the $V_{ds}$, control circuit.

A single stage VGA amplifier with linearization circuitry as described above that utilizes current steering and $V_{ds}$, control could yield a gain control range in excess of 40 dB.

The second method of VGA gain control is $V_{ds}$ control. Linearity in amplifier output tends to be improved by $V_{ds}$ control or" $V_{ds}$ squeezing." With current steering, no provision is made for improving linearity once the input signal becomes large.

Linearity is typically determined by the $g_m$ of each of the two differential amplifier stages. The first stage comprises M10 and M4. The second stage comprises M13 and M14. The embodiment described tends to have an increased linearity of 26 dB, corresponding to a factor of 20 improvement in linearity over that typically available.

VGA operating conditions determine the distribution the currents iSig and iAtten. When a small signal is applied to the input terminals $\pm V_{in}$ and -$V_{in}$ it is typically desirable to amplify the signal with a high gain setting. Transistors M10 and M4 are coupled to the differential output so that their $g_m$s tend to contribute to VGA overall gain. However, transistors M13 and M14 are coupled to the VGA output so that their $g_m$s tend to decrease VGA gain through a $g_m$ subtraction. Transistors M4 and M10 are controlled by iSig, transistors M13 and M14 are controlled by iAtten.

For a high gain condition, $g_m$ subtraction is undesired..

Thus, for a high gain setting, it is desirable to have most of the gain available from devices M10 and M4 contributing to the amplifier's overall gain. M10 and M4 are set for maximum gain by setting iSig to a maximum current. Correspondingly iAtten is set to a low value of current. In achieving a maximum gain, a control current is divided between iSig and iAtten such that a maximum current is present in the iSig line.

In the low gain state, the second differential pair transistors M13 and M14 are controlled by iAtten such that they subtract from the gain of M10 and M4. A large gain present for devices M13 and M14 creates a large gain subtraction in devices M10 and M4 which are controlled by iSig to produce a minimum gain.

Thus, when the signal input is small, minimum gain on M13 and M14 is desired and maximum gain on M10 and M4 is desired to produce maximum VGA gain. When the input signal is large, a maximum gain on M13 and M14 is desired and minimum gain on M10 and M4 is desired to produce minimum VGA gain.

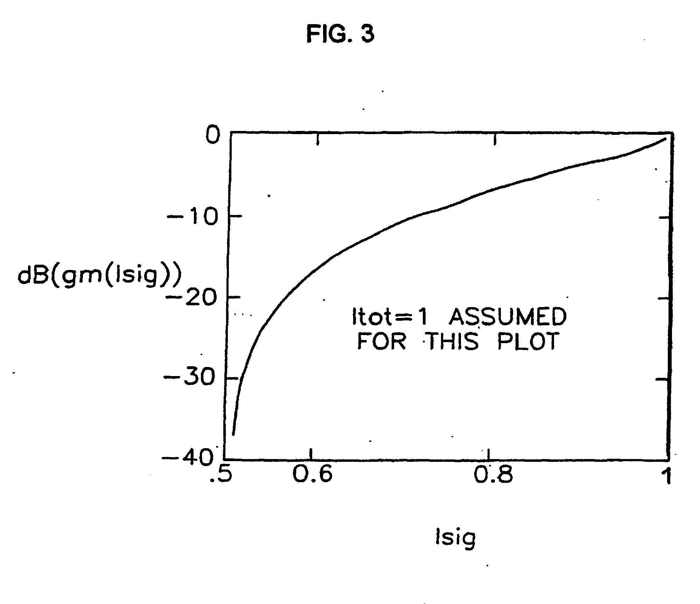

FIG. 3 is a graph of gain versus the control current iSig. Control current iSig is shown as a fraction of iAtten, with the total current being equal to 1, or 100%. At the far right of the graph, a 0 dB reference is set corresponding to maximum amplifier gain of maximum amplifier $g_m$. As iSig is reduced, control current iAtten is increasing proportionately causing the VGA's overall $g_m$ and gain to decrease.

Maximum VGA gain is desirable with a small input signal present at the VGA input. Maximum gain is achieved with a maximum current into the iSig control line and minimum current into the iAtten control line. As the signal at the VGA input becomes larger, it is desired to decrease the amplifier gain. A reduction in VGA gain is achieved by decreasing the current in the iSig line and increasing the current in the iAtten control line. A minimum VGA gain corresponds to maximum current in the iAtten control line and minimum current into the iSig line.

Returning to FIG. 2, the linearization circuit takes the externally supplied control signal 7406 that is provided as a voltage and converts it to control signals 7404 that are current and voltage signals. In the current steering circuit 7512 a maximum control signal voltage amplified in the embodiment described corresponds to a maximum gain condition with iSig set to a maximum and iAtten being set to a minimum. As the control voltage is decreased, iSig decreases and iAtten increases.

The control voltage Vc 7406 is created by digital circuitry that is responsive to the input level of the amplifier. In the embodiment described the gain control loop is closed in a digital circuitry domain located off of chip that produces control signal 7404.

The output of the VGA is sampled to determine if sufficient signal strength is available for further signal processing. The sample is processed by an A to D converter into a digital signal, and the control voltage responsive to the level ofthe VGA output is created. Alternatively, analog methods may be used to sample the output and generate control voltage. In an embodiment the VGA is utilized as an IF VGA. In alternate embodiments the VGA is configured for used at other frequency bands that require an adjustment in gain.

Stability of the AGC loop is maintained during changes in iSig and iAtten. Stability is achieved in the minimum gain setting by keeping iSig greater than iAtten. In the embodiment described iSig is prevented from becoming less than iAtten by the linearization circuit. If iSig becomes less than iAtten, phase inversion problems tend to occur causing a degradation in VGA performance, disrupting automatic gain control ("AGC") loop performance in a receiver. This condition is prevented from happening by providing appropriate circuitry in the linearization circuit.

Also with respect to AGC loop stability, a zero gain setting is undesirable. In the embodiment, the transistors are fabricated with identical dimensions, and it is possible to set the gain equal to zero by making the iSig and iAtten currents equal. This is undesirable from a control loop stability standpoint. The linearization circuit provides appropriate circuitry preventing this condition from occurring.

Maximum attenuation is determined by how close iSig is allowed to approach iAtten in value. Thus, the maximum attenuation achieved is dependent upon the stability that is permissible as iSig approaches iAtten.

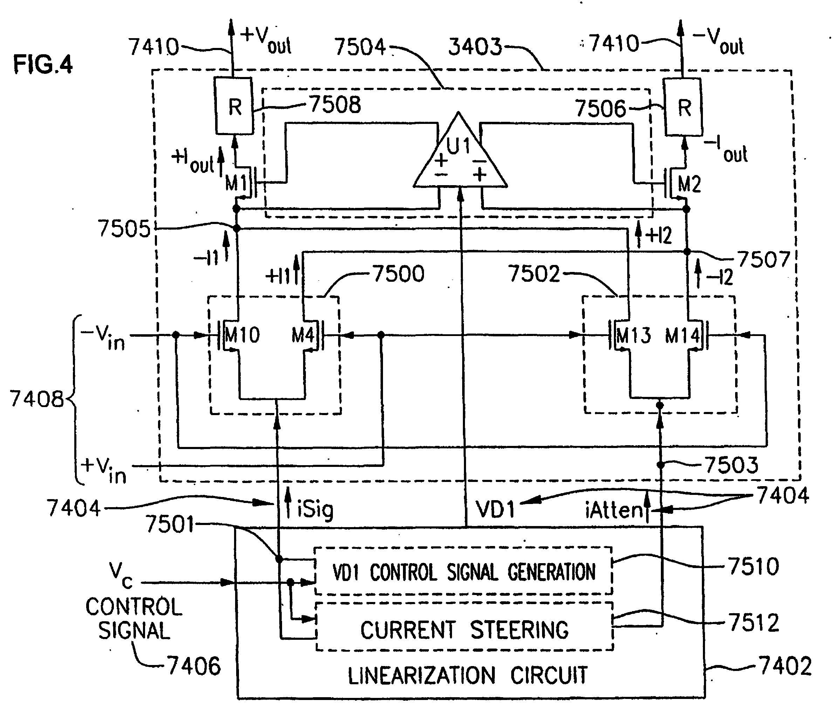

FIG. 4 is the schematic diagram of an embodiment of the VGA. The VGA has a control circuit to control the $V_{ds}$ of M10 and M13 at node 7505, and the $V_{ds}$ of M4 and M14 at node 7507.

A control voltage VD1 is generated by the linearization circuit 7510 and applied to control a differential amplifier U1. The negative input of U1 is coupled to node 7505, and the positive input of U1 is coupled to node 7507.

A transistor M1 has its source coupled to node 7505, its drain comprises the $+I_{out}$ terminal of the VGA. The gate of transistor M1 is coupled to the positive output of U1. A transistor M2 has its source coupled to node 7507, its drain comprises the $-I_{out}$ terminal of the VGA. The gate of transistor M2 is coupled to the negative output of A1.

The $V_{ds}$ squeezing is utilized since it tends to improve linearity. As the control signal voltage increases, the control voltage VD1 decreases tending to decrease the VGA gain. As previously discussed, iSig is decreasing and iAtten is increasing to achieve the desired decrease in VGA gain. Concurrently with $V_{ds}$, squeezing, the $V_{ds}$, of all four transistors M10, M4, M13, M14 also tends to decrease with increasing input signal level due to the application of a variable DC voltage at the transistor source leads. A DC voltage is fixed at nodes 7501 and 7503. Thus, the way available to reduce $V_{ds}$, for M10, M4, M13, and M14 is to reduce the DC voltage at the $+I_{out}$ and $-I_{out}$ terminals. A variable voltage source is connected at each node $+I_{out}$ and $-I_{out}$ 7505, 7507.

The sources of M13 and M14 are coupled in common to node 7503 and to the control signal iAtten. Control signal iAtten tends to cause a decrease in amplifier gain, while control signal iSig tends to increase amplifier gain. The sources of M10 and M4 are coupled in common to iSig at node 7510. The drains of M10 and M13 are coupled in common to provide an output signal $+I_{out}$. The drains ofM4 and M14 are coupled in common to provide an output signal $-I_{out}$. In the exemplary embodiment input $-V_{in}$ is coupled to the gates of M10 and M14. Input $+V_{in}$ is coupled to the gates of M4 and M13. In the exemplary embodiment differential inputs and outputs are shown in the amplifier. However, it is understood by those skilled in the art that a single ended configuration is equivalently produced by the use of a device such as a balun.

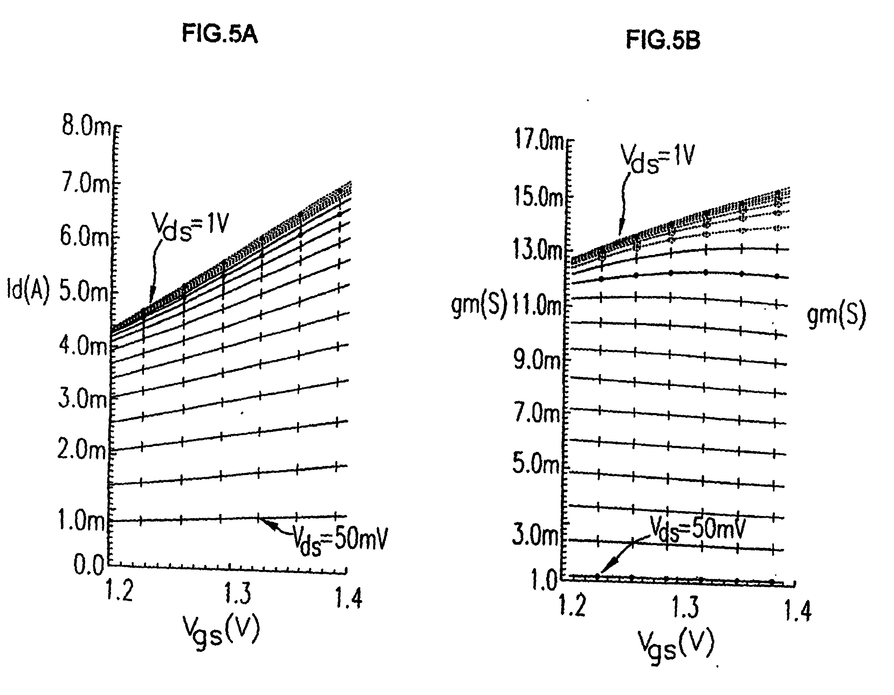

FIG. 5a illustrates a family of curves showing the relationship of a transistor's drain current ("$I_d$") to its gate source voltage ("$V_{gs}$") measured at each of a series of drain source voltages ("$V_{ds}$") from 50 mV to I V. From this graph a transconductance, $g_m$ is determined. The following relationship defines a $g_m$ curve for each $V_{ds}$ value:

$$g_m = \frac{dI_d}{dV_{gs}} \qquad (2)$$

FIG. 5b is a graph of $g_m$ verses $V_{gs}$, as $V_{ds}$ is varied from 50 mV to 1 V. To provide improved output linearity performance, it is desirable to operate a transistor on a curve of $g_m$, that has a constant value and zero slope. As seen in the graph for a $V_{ds}$ of approximately 50 mV, the curves of $g_m$ verses $V_{gs}$ tend to be flat. As $V_{ds}$ is increased, the curve begins to slope, indicating the presence of non-linearity in the output signal. As $V_{ds}$ increases the curve not only begins to slope, but it develops a bow, further complicating the compensation for the non-linearities at the higher level of $V_{ds}$. These irregularities in $g_m$ tend to be the sources of non-linearities in the output of the amplifier. Thus, it is desired to provide a flat $g_m$ response to produce a more linear transfer function for the VGA by controlling $V_{ds}$.

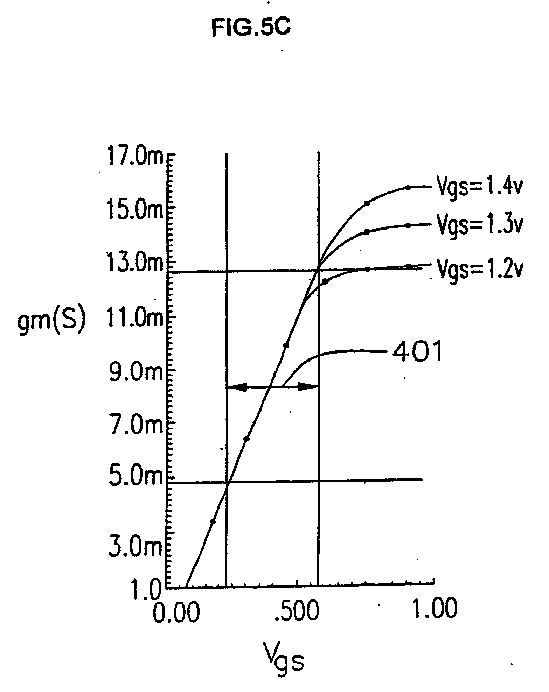

FIG. 5c is a graph of the cross-section of FIG. 5b plotting $g_m$ verses $V_{ds}$ for various values of $V_{gs}$. As $V_{ds}$, changes from approximately 200 mV to 500 mV, $g_m$ changes from approximately 5 mS to 13 mS. The change in $g_m$ from 5 mS to 13 mS by changing $V_{ds}$ may be used to control gain. Thus, as $V_{ds}$, is decreased, the gain is decreased. Control of $V_{ds}$ provides approximately 9 dB of gain control range.

Within the range of $V_{ds}$, graphed between the vertical bars 7801, the value for $g_m$ remains essentially the same for a range of $V_{gs}$ input signal from 1.2 V to 1.4 V. Thus by controlling $V_{ds}$ from 200 mV to 600 mV approximately 9 dB of gain control is provided.

When control of $V_{ds}$ is combined with the $g_m$ subtraction method previously described, the linear output signal is maintained. In addition approximately 8 dB to 9 dB of gain control in addition to that provided by $g_m$ subtraction contributes to provide overall VGA gain control on the order of 30 dB, in the exemplary embodiment.

Output linearity is often quantitized by measuring an intermodulation product produced by two input signals present at differing frequencies. For the VGA a two tone intermodulation ("IM") product test is utilized, and the distortion as represented by the third order intermodulation product is measured. Approximately a 26 dB decrease in the third order IM product tends to be achieved in the exemplary embodiment.

With the input signal maintained at a constant level, the output signal at +$I_{out}$ and -$I_{out}$ is measured as gain squeezing is performed. Improvement is measured as compared to adjusting gain without utilizing gain squeezing. A reduction in third order intermodulation of approximately 25 dB is measured as $V_{ds}$ is squeezed within a range of approximately 150 mV to 200 mV. Utilizing a test having two tones at 44 MHz and 45 MHz typically produces third order intermodulation product components at 43 MHz and 46 MHz. With this test, 20 dB to 25 dB improvement in third order intermodulation is observed in the exemplary embodiment. A typical improvement of 20 dB is realized in the linearity of the output signal.

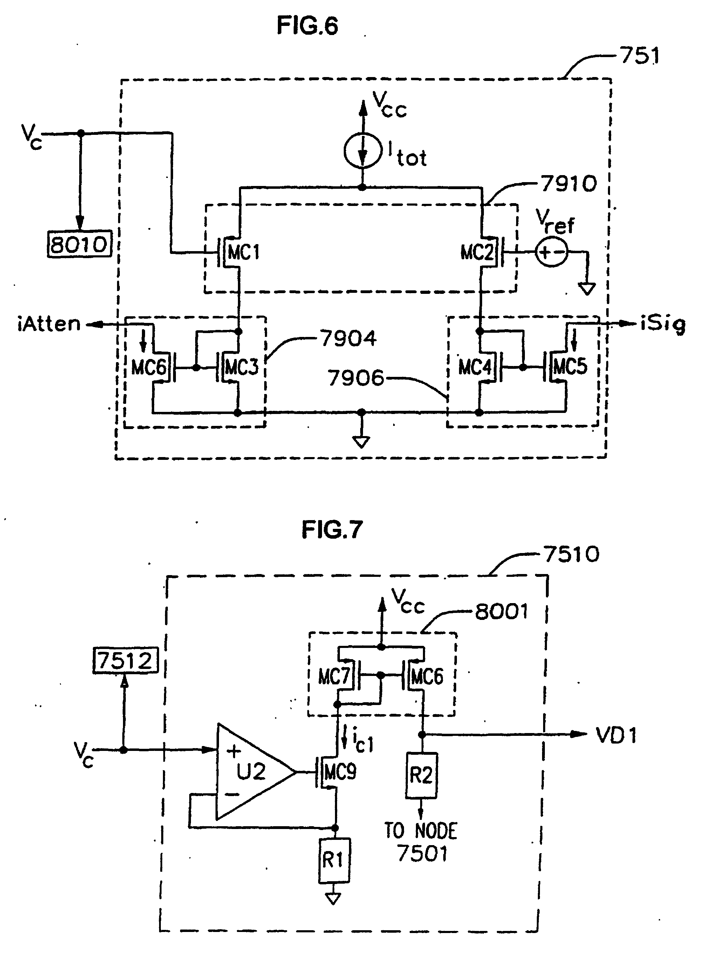

FIG. 6 is a schematic of a current steering circuit. An external control signal $V_c$ drives a differential pair amplifier 7910 including MC1, MC2, to ultimately generate iSig and iAtten. The iSig and iAtten are generated through two current mirrors 7904, 7906. The first current mirror 7904 comprises MC3 and MC6. The second current mirror 7906 comprises MC4 and MCS. The circuit maintains a fixed relationship between iSig and iAtten, defined by:

$$I_{tot} = iSig + iAtten \tag{3}$$

To guarantee that phase reversal does not occur, iSig must remain greater than iAtten at all times. By selecting $V_{ref}$ to be slightly less than the minimum value of control voltage $V_c$ that will be present, iSig will remain greater than iAtten.

In an embodiment of current steering circuit 7512, a control voltage $V_c$ is applied to a differential pair amplifier 7910. In the exemplary embodiment, control signal $V_c$ ranges from 0.5 V to 2.5 V. The 0.5 V corresponds to a minimum gain setting and 2.5 V corresponds to a maximum gain setting. Differential pair amplifier 7910 comprises two transistors MC1 and MC2. In the exemplary embodiment, field effect transistors are used. Equivalently, other types of transistors may be substituted for field effect devices. The inputs to the differential pair amplifier are the gates of MC1 and MC2. The sources of MC1 and MC2 are coupled in common to a current source $I_{tot}$. Current source $I_{tot}$ is in turn coupled to a supply voltage $V_{cc}$. Current source $I_{tot}$ is conventional current source constructed as is known by those skilled in the art.

The drains of MC1 and MC2 are coupled to current mirrors 7904 and 7906, respectively. Control voltage $V_c$ is coupled to the gate of MC1 and a voltage reference is coupled to the gate of MC2. Voltage reference $V_{ref}$ is typically constructed as conventional voltage source known to those skilled in the art. The currents present in the sources of MC1 and MC2 drive current mirrors 7904 and 7906, respectively. Current mirror 7904 comprises transistors MC6 and MC3 Current mirror 7906 comprises transistors MC4 and MC5. These current mirrors are constructed conventionally as is known by those skilled in the art. Output of current mirror 7904 and 7906 consists of the control signals iAtten and iSig.

FIG. 7 is a schematic of a VD1 control signal generation circuit. Control signal $V_c$ fed to the positive input of a differential amplifier U2. Signal ended output of amplifier U2 is fed into the gate of transistor MC9. The source of MC9 is connected to the negative input of U2. The source of MC9 is also coupled to a first terminal of a resistor R1. A second terminal of R1 is coupled to ground. The drain of MC9 receives a current $i_{c1}$ that is supplied by a drain of transistor MC7. The drain of MC7 is coupled to the gate of MC7. The source of MC7 is coupled to a supply voltage

$V_{cc}$. The gate of MC7 is coupled to the gate of MC6. The source of MC6 is coupled to a supply voltage $V_{cc}$. The drain of MC6 is coupled to a first terminal of a resistor R2. The second terminal of resistor R2 is coupled to node 1001. The node formed by coupling MC6 to R2 supplies control signal VD1. Together transistors MC7 and MC6 form a current mirror 8001.

Control current $V_c$ sets up the control current $i_{c1}$ through amplifier U2, resistor R1 and transistor MC9. Current $i_{c1}$ is mirrored through transistor MC7 and MC8 ofthe current mirror. The current generated in the drain lead of MC6 creates a voltage across resistor R2 as reference to the voltage present on node 7501. Thus, R1 and R2 are sized properly to control $V_{ds}$, across M10, M4, M13 and M14. For example, VD1 can range from 100 mV to 600 mV. This condition corresponds to a $V_c$ = 05V at a minimum gain maximum input condition and a 2.5V maximum gain minimum input signal condition.

In alternative embodiments, control voltage $V_c$ may be subjected to conditioning by temperature compensation circuitry and linear in dB transfer function compensation before being applied to the VD1 generation circuit 7510.

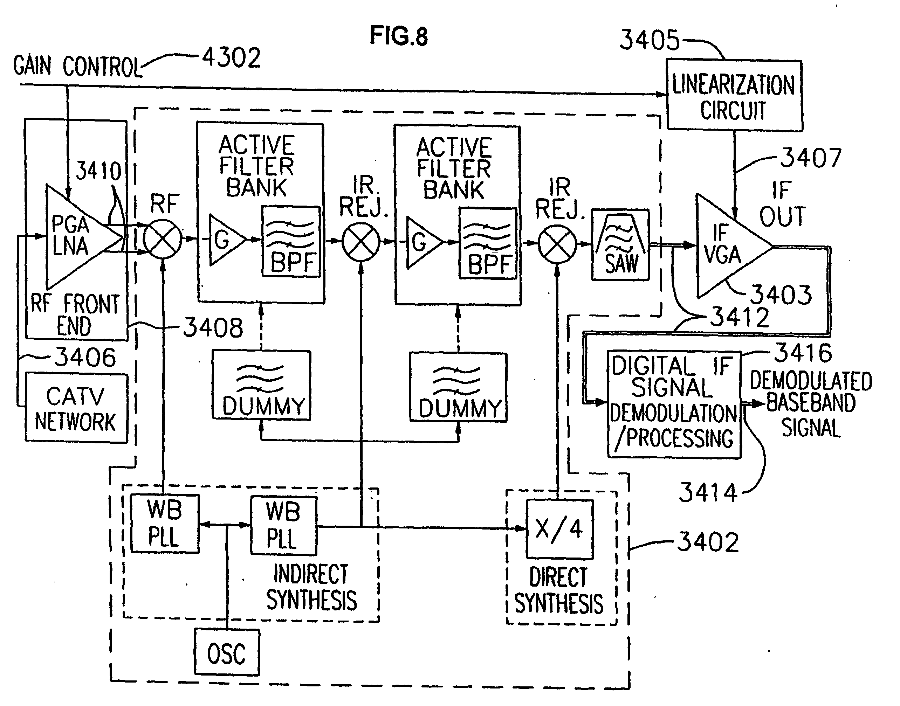

FIG. 8 is a block diagram of a communications network utilizing a receiver 3402 according to an exemplary embodiment of the invention. A communications network, such as a cable TV network 3404, capable of generating signals provides radio frequency ("RE") signals 3406 over the air waves, through a cable or other transmission medium. Such a signal is typically single ended, although differential transmission is contemplated. A receiver front end 3408 next converts the RF single ended signal to a differential signal. In the embodiment shown the front end provides low noise amplification of a weak received signal by a low noise amplifier. The embodiment shown also includes an attenuator to reduce a strong received signal's level. An externally supplied control signal 4302 controls the amount of attenuation, or gain of the RF signal. A receiver front end, or a Balun may be used to convert a single ended signal 3406 to a differential signal or vise versa 3410.

The receiver block 3402 which contains an exemplary embodiment of the invention next converts the differential radio frequency signal 3410 to a differential intermediate frequency (IF) 3412. Equivalently, single ended signals, or a mixture of differential and single ended signals are utilized in the receiver block 3402.

A large gain range high linearity, low noise MOS variable gain amplifier ("VGA")3403 is present to adjust the IF signal level 3412. A control voltage 3407 controls the gain of the IF signal such that a linear control voltage verses gain response is produced. A linearization circuit 3405 produces the linear control voltage from the control signal input 4302. The IF signal 3412 is next converted down to DC and demodulated into a base band signal 3414 by a demodulator 3416. At this point the base band signal 3414 is suitable for presentation to the video input of a television receiver, the audio inputs to a stereo, a set top box, or other such circuitry that converts the base band signal into the intended information output.

The communication system described is contemplated ito provide the function described above in one or more circuit assemblies, integrated circuits or a mixture of these implementations. In particular, the RE front end 3408 may be integrated in a single chip with receiver 3402. Alternatively, the front end and receiver may be implemented as individual integrated circuits, on any suitable material such as CMOS.

In addition, the receiving system described utilizes additional exemplary embodiments that incorporate one or more transmitters and one or more receivers to form a "transceiver" or "multiband transceiver." The transceiver contemplated may transmit and receive on differing frequencies or the same frequency with appropriate diplexer, transmit receive switching or functionally equivalent circuitry.

The frequency bands and modulation described in the specification are exemplary with the inventions not being limited in scope to any particular frequency band or modulation type.

To achieve a low noise figure what is left out of the circuit is often as important as what is included in it to achieve a low noise figure. A circuit containing few components in desirable since each component in a circuit adds to noise generated in the circuit. Switches are often included early in a signal path to switch in attenuator sections, reducing the level of a signal present. The reduction in signal level is necessary to prevent a following receiver circuit from being over driven into distortion.

In an embodiment a large gain range, high linearity, low noise MOS VGA 3403 is used as an automatic gain control ("AGC") amplifier. Additionally, the circuit described as a front end circuit may also be employed as an AGC amplifier. The AGC amplifier may advantageously be used at any point in the signal processing chain where an adjustable gain and adjustable attenuation according to an external control signal is desired.

In one specific embodiment, a control signal 4302 from an external pin on the integrated circuit is applied to RE front end 3408 and an IF AGC amplifier 3404. The control signal applied to the IF AGC amplifier 3403 is first conditioned by a linearization circuit 3405 so that a linear control of the IF AGO amplifier's gain is produced by varying the control signal 4302. The signal output by the linearization circuit 3405 is a control voltage 3407.

By way of example, control signal 4302 could be formed by sampling the sync pulses of the base band television signal and averaging the amplitude of the sync pulses over a period of time.

Advantageously, the present invention has eliminated the need for switches, reducing a major contributor to increased noise figure. In an integrated switchless programmable attenuator and low noise amplifier only two elements are present in the signal path to contribute to the noise figure. First an attenuator is present m the circuit path. The next element in series with the attenuator in the signal path is a differential pair low noise (LNA) amplifier. In the differential pair noise figure is lowered by introducing a sufficient bias current to increase a transconductance $g_m$ associated with the amplifier. The increased $g_m$ decreases the noise contribution of the differential pair.

By eliminating the need for switches it is possible to integrate the programmable attenuator and LNA onto a single CMOS integrated circuit. An additional advantage can be realized in using an integrated programmable attenuator and LNA as a "front end" of an integrated receiver. A single integrated circuit can be economically fabricated on CMOS that contains an entire tuner circuit including the front end and the tuner. Alternatively, the front end and tuner circuits may be on separate interconnected substrates.

**Claims**

1. An integrated MOS VGA (3403) having improved dynamic range comprising:

   a first differential pair amplifier (7500) disposed upon the substrate and coupled to a VGA output having a gain contributing to VGA gain in direct proportion to the first differential pair amplifier gain;
   a second differential pair amplifier (7502) disposed upon the substrate and coupled to the VGA output having a gain, and coupled to the first differential amplifier (7500) such that an increase in second differential pair amplifier gain contributes in inverse proportion to the VGA gain; and **characterised by**
   a substrate on which the first and second differential pair amplifiers (7500, 7502) are disposed; and
   a fixed control current split between the first differential pair amplifier (7500) and the second differential pair amplifier (7502) such that current to the second differential pair amplifier source connection is not greater than current applied to the first differential pair amplifier source connection and applied such that an increase in current causes an increase in amplifier gain.

2. The integrated MOS VGA (3403) of claim 1 further comprising:

   a variable voltage source (7510) coupled to the VGA output controlling differential pair gain;
   a control signal (7406) applied to the variable voltage source to control its level.

3. An integrated MOS VGA (3403) having an improved dynamic range comprising:

   a differential variable gain amplifier (U1); and
   a linearization circuit (7402) producing a pair of currents simultaneously applied to the integrated MOS VGA (3403), consisting of a first current (iSig) and a second current (iAtten) that are applied to the integrated MOS VGA (3403) for controlling amplifier gain, such that when the first current (iSig) increases VGA gain tends to increase, and that when the second current (iAtten) increases VGA gain tends to decrease.

4. The integrated MOS VGA (3403) of claim 3 in which the linearization circuit (7402) further comprises the first current (iSig) maintaining a value greater than the second current (iAtten).

5. A method for providing, over a wide range of input signal voltages, variable gain amplification having a linear change in output current gain at a differential current output port as a function of a change in differential voltage input (7408) at a differential voltage input port, comprising the steps of:

   providing an input control voltage derived from the differential input voltage (7408);
   providing a variable gain amplifier (3403) responsive to the differential input voltage (7408), the variable gain amplifier (3403) having:

   a first common source differential pair amplifier (7500), the first common source differential pair amplifier (7500) having first common source differential pair output drains;
   a second common source differential pair amplifier (7502), the second common source differential pair amplifier (7502) having second common source differential pair output drains; and **characterised in that**
   the first common source differential pair output drains and the second common source differential pair output drains being connected in parallel to form the differential current output port and being responsive to the differential input voltage to provide the output current gain at the differential current output port; and further **characterised by**

deriving a first variable gain control signal from the input control voltage ($V_c$) and providing the first variable control signal to the first common source differential pair amplifier (7500) to control maximizing gain of the first common source differential pair amplifier (7500) when the input control voltage ($V_c$) is low and minimizing gain of the first common source differential pair amplifier (7500) when the input control voltage ($V_c$) is high;

deriving a second variable gain control signal from the input control voltage and providing the second variable gain control signal to the second common source differential pair amplifier (7502) to control minimizing gain of the second common source differential pair amplifier (7502) when the input control voltage ($V_c$) is low and maximizing gain of the second common source differential pair amplifier (7502) when the input control voltage($V_c$) is high; and

maintaining the first gain control signal in relationship to the second gain control signal such that the second gain control signal is less than the first gain control signal; and reducing first common source differential pair amplifier drain-source Vds voltages and second common source differential pair amplifier drain-source Vds voltages as the differential input voltage increases.

6. The method of claim 5 wherein the step of reducing includes the step of reducing absolute direct current voltage at the differential current output port.

7. The method of claim 6 wherein the step of reducing absolute direct current voltage includes the steps of:

coupling a voltage control source across the differential current output port; and inputting a third gain control signal derived from the input control voltage to control the voltage control source to reduce absolute direct current voltage at the differential current output port as the differential input voltage increases.

**Patentansprüche**

1. Integrierter Verstärker (3403) in MOS-Technologie mit variabler Verstärkung (MOS-VGA) und verbessertem Dynamikbereich mit:

einem ersten Differenzpaar-Verstärker (7500), der auf dem Substrat angeordnet ist, mit einem VGA-Ausgang gekoppelt ist und eine Verstärkung aufweist, deren Beitrag zu der VGA-Verstärkung direkt proportional ist; und einem zweiten Differenzpaar-Verstärker (7502), der auf dem Substrat angeordnet ist, mit dem VGA-Ausgang gekoppelt ist und eine Verstärkung aufweist und so mit dem ersten Differenzverstärker (7500) gekoppelt ist, daß die VGA-Verstärkung umgekehrt proportional von einer Erhöhung der Verstärkung des zweiten Differenzpaar-Verstärkers abhängt, und **gekennzeichnet durch**
ein Substrat, auf dem der erste Differenzpaar-Verstärker (7500) und der zweite Differenzpaar-Verstärker (7502) angeordnet sind; und
eine festgelegte gesteuerte Stromaufteilung zwischen dem ersten Differenzpaar-Verstärker (7500) und dem zweiten Differenzpaar-Verstärker (7502), die so erfolgt, daß der Strom zu der Sourceverbindung des zweiten Differenzpaar-Verstärkers nicht größer ist als der Strom zu der Sourceverbindung des ersten Differenzpaar-Verstärkers und eine Stromerhöhung zu einer Erhöhung der Verstärkung des Verstärkers führt.

2. Integrierter MOS-VGA (3403) nach Anspruch 1, der darüber hinaus

eine mit dem VGA-Ausgang gekoppelte Spannungsquelle (7510) mit variabler Spannung aufweist, die die Verstärkung der Differenzpaare steuert;
und ein Steuersignal (7406) aufweist, das an die Spannungsquelle mit variabler Spannung angelegt wird, um ihren Spannungspegel zu steuern.

3. Integrierter MOS-VGA (3403) mit einem verbessertem Dynamikbereich mit:

einem Differenzverstärker (U1) mit variabler Verstärkung; und
einer Linearisierungsschaltung (7402), die ein Paar aus Strömen erzeugt, die gleichzeitig an den integrierten MOS-VGA (3403) angelegt werden, wobei das Paar einen ersten Strom (iSig) und einen zweiten Strom (iAtten) umfaßt, die an den integrierten MOS-VGA (3403) angelegt werden, um die Verstärkung des Verstärkers zu steuern, so daß die VGA-Verstärkung dann einer Erhöhung zustrebt, wenn sich der erste Strom (iSig) erhöht, und die VGA-Verstärkung dann einer Verminderung zustrebt, wenn sich der zweite Strom (iAtten) erhöht.

**4.** Integrierter MOS-VGA (3403) nach Anspruch 3, bei dem die Linearisierungsschaltung (7402) darüber hinaus so ausgebildet ist, daß der erste Strom (iSig) auf einem Wert gehalten wird, der größer als der zweite Strom (iAtten) ist.

**5.** Verfahren zum Bereitstellen einer Verstärkung mit einem variablen Verstärkungsfaktor über einen großen Bereich von Eingangssignalspannungen mit einer linearen Änderung der Ausgangsstromverstärkung an einem differentiellen Ausgangsstromanschluß in Abhängigkeit von einer Veränderung einer differentiellen Eingangsspannung (7408) an einem differentiellen Eingangsspannungsanschluß, bei dem

eine Eingangssteuerspannung bereitgestellt wird, die von einer differentiellen Eigangsspannung (7408) abgeleitet ist;

und ein Verstärker (3403) mit variabler Verstärkung bereitgestellt wird, der auf die differentielle Eingangsspannung (7408) anspricht, wobei der Verstärker (3403) mit variabler Verstärkung

einen ersten Differenzpaar-Verstärker (7500) mit miteinander verbundenen Sourceanschlüssen und ersten Drainausgängen;

und einen zweiten Differenzpaar-Verstärker (7502) mit miteinander verbundenen Sourceanschlüssen und zweiten Drainausgängen, aufweist;

wobei die ersten Drainausgänge und die zweiten Drainausgänge parallel geschaltet sind, um den differentiellen Stromausgangsanschluß zu bilden und auf die differentielle Eingangsspannung zu reagieren, um die Ausgangsstromverstärkung an dem differentiellen Stromausgangsanschluß zu bilden; und darüber hinaus **gekennzeichnet dadurch, daß**

von der Eingangssteuerspannung ($V_c$) ein erstes Steuersignal für eine variable Verstärkung abgeleitet und an den ersten Differenzpaar-Verstärker (7500) mit miteinander verbundenen Sourceanschlüssen angelegt wird, um die Maximierung der Verstärkung des ersten Differenzpaar-Verstärkers (7500) mit miteinander verbundenen Sourceanschlüssen zu steuern, wenn die Eingangssteuerspannung ($V_c$) niedrig ist, und um die Minimierung der Verstärkung des ersten Differenzpaar-Verstärkers (7500) mit miteinander verbundenen Sourceanschlüssen zu steuern, wenn die Eingangssteuerspannung ($V_c$) hoch ist;

von der Eingangssteuerspannung ($V_c$) ein zweites Steuersignal für eine variable Verstärkung abgeleitet und an den zweiten Differenzpaar-Verstärker (7502) mit miteinander verbundenen Sourceanschlüssen angelegt wird, um die Minimierung der Verstärkung des zweiten Differenzpaar-Verstärkers (7502) mit miteinander verbundenen Sourceanschlüssen zu steuern, wenn die Eingangssteuerspannung ($V_c$) niedrig ist, und um die Maximierung der Verstärkung des ersten Differenzpaar-Verstärkers (7500) mit miteinander verbundenen Sourceanschlüssen zu steuern, wenn die Eingangssteuerspannung ($V_c$) hoch ist;

das Verhältnis zwischen dem ersten Verstärkungssteuersignal und dem zweiten Verstärkungssteuersignal so aufrechterhalten wird, daß das zweite Verstärkungssteuersignal schwächer als das erste Verstärkungssteuersignal ist; und die Drain-Source-Spannungen (Vds) des ersten Differenzpaar-Verstärkers mit miteinander verbundenen Sourceanschlüssen und die Drain-Source-Spannungen (Vds) des zweiten Differenzpaar-Verstärkers mit miteinander verbundenen Sourceanschlüssen vermindert werden, wenn die differentielle Eingangsspannung steigt.

**6.** Verfahren nach Anspruch 5, bei dem bei dem Vermindern der Absolutwert der zu dem Gleichstrom gehörenden Spannung an dem differentiellen Stromausgangsanschluß vermindert wird.

**7.** Verfahren nach Anspruch 6, bei dem bei dem Schritt des Verminderns des Absolutwerts der zu dem Gleichstrom gehörenden Spannung

eine Spannungssteuerquelle mit dem differentiellen Stromausgangsanschluß gekoppelt wird; und ein drittes Verstärkungssteuersignal eingegeben wird, das von der Eingangssteuerspannung abgeleitet wird, um die Spannungssteuerquelle zu steuern, um den Absolutwert der zu dem Gleichstrom gehörenden Spannung an dem differentiellen Stromausgangsanschluß zu vermindern, wenn die differentielle Eingangsspannung ansteigt.

**Revendications**

**1.** Amplificateur MOS intégré à gain variable (3403) ayant une plage dynamique améliorée comprenant :

un premier amplificateur à paire différentielle (7500) disposé sur le substrat et relié à une sortie VGA ayant un gain contribuant au gain VGA en proportion directe au gain du premier amplificateur à paire différentielle ; un second amplificateur à paire différentielle (7502) disposé sur le substrat et relié à la sortie VGA ayant un gain, et relié au premier amplificateur à paire différentielle (7500) de sorte qu'une augmentation en gain du second amplificateur à paire différentielle contribue en proportion inverse au gain VGA, et **caractérisé en ce**

**que**

un substrat sur lequel les premier et second amplificateurs à paire différentielle (7500, 7502) sont disposés ; et un courant de commande fixe divisé entre le premier amplificateur à paire différentielle (7500) et le second amplificateur à paire différentielle (7502) de sorte que le courant vers la connexion source du second amplificateur à paire différentielle ne soit pas supérieur au courant appliqué à la connexion source du premier amplificateur à paire différentielle et appliqué de telle sorte qu'une augmentation du courant provoque une augmentation du gain de l'amplificateur.

**2.** Amplificateur MOS intégré à gain variable (3403) selon la revendication 1 comprenant en outre :

une source de tension variable (7510) reliée à la sortie VGA contrôlant le gain de paire différentielle ;
un signal de commande (7406) appliqué à la source de tension variable pour contrôler son niveau.

**3.** Amplificateur MOS intégré à gain variable (3403) ayant une plage dynamique améliorée comprenant :

un amplificateur différentiel à gain variable (U1) ; et
un circuit de linéarisation (7402) produisant une paire de courants appliqués simultanément au MOS VGA intégré (3403), consistant en un premier courant (iSig) et un second courant (iAtten) qui sont appliqués au MOS VGA intégré (3403) pour contrôler le gain de l'amplificateur, de sorte que lorsque le premier courant (iSig) augmente, le gain VGA tend à augmenter, et que lorsque le second courant (iAtten) augmente le gain VGA tend à diminuer.

**4.** Amplificateur MOS intégré à gain variable (3403) de la revendication 3 dans lequel le circuit de linéarisation (7402) comprend en outre le premier courant (iSig) maintenant une valeur supérieure au second courant (iAtten).

**5.** Procédé pour proposer, sur une large plage de tensions de signaux d'entrée, une amplification à gain variable ayant un changement linéaire en gain du courant de sortie à un port de sortie de courant différentiel en fonction d'un changement dans l'entrée de tension différentielle (7408) à un port d'entrée de tension différentielle, comprenant les étapes consistant à :

proposer une tension de commande d'entrée dérivée de la tension d'entrée différentielle (7408) ;
proposer un amplificateur à gain variable (3403) réagissant à la tension d'entrée différentielle (7408), l'amplificateur à gain variable (3403) ayant :

un premier amplificateur à paire différentielle de source commune (7500), le premier amplificateur à paire différentielle de source commune (7500) ayant des premiers drains de sortie à paire différentielle de source commune ;
un second amplificateur à paire différentielle (7502) de source commune, le second amplificateur à paire différentielle de source commune (7502) ayant des seconds drains de sortie à paire différentielle de source commune, et **caractérisé en ce que**
les premiers drains de sortie à paire différentielle de source commune et les seconds drains de sortie à paire différentielle de source commune étant connectés en parallèle pour former le port de sortie de courant différentiel et réagissant à la tension d'entrée différentielle pour fournir le gain de courant de sortie au port de sortie de courant différentiel ; et **caractérisé en outre par**
l'obtention d'un premier signal de commande de gain variable de la tension de commande d'entrée ($V_c$) et la fourniture du premier signal de commande variable au premier amplificateur à paire différentielle de source commune (7500) pour commander la maximisation du gain du premier amplificateur à paire différentielle de source commune (7500) lorsque la tension de commande d'entrée ($V_c$) est basse et la minimisation du gain du premier amplificateur à paire différentielle de source commune (7500) lorsque la tension de commande d'entrée ($V_c$) est haute ;
l'obtention d'un second signal de commande de gain variable à partir de la tension de commande d'entrée et la fourniture du second signal de commande à gain variable au second amplificateur à paire différentielle de source commune (7502) pour contrôler la minimisation du gain du second amplificateur à paire différentielle de source commune (7502) lorsque la tension de commande d'entrée ($V_0$) est basse et la maximisation du gain du second amplificateur à paire différentielle de source commune (7502) lorsque la tension de commande d'entrée ($V_c$) est haute ; et
le maintien du premier signal de commande de gain par rapport au second signal de commande de gain de sorte que le second signal de commande de gain soit inférieur au premier signal de commande de gain ; et la réduction des premières tensions Vds drain-source de l'amplificateur à paire différentielle de source commune et les secondes tensions Vds drain-source de l'amplificateur à paire différentielle de source commune lorsque la tension d'entrée différentielle augmente.

6. Procédé de la revendication 5 dans lequel l'étape de réduction comprend l'étape consistant à réduire la tension absolue de courant continu au port de sortie du courant différentiel.

7. Procédé de la revendication 6 dans lequel l'étape de réduction de la tension de courant continu absolu comprend les étapes consistant à :

relier une source de commande de tension à travers le port de sortie de courant différentiel ; et
entrer un troisième signal de commande de gain dérivé de la tension de commande d'entrée pour contrôler la source de commande de tension pour réduire la tension de courant continu absolu au port de sortie du courant différentiel lorsque la tension d'entrée différentielle augmente.

FIG. 1

FIG.2

**FIG. 3**

FIG.4

LINEARIZATION CIRCUIT

VD1 CONTROL SIGNAL GENERATION

CURRENT STEERING

FIG.5B

gm(S)

$V_{ds}=1V$

$V_{ds}=50mV$

$V_{gs}(V)$

gm(S)

FIG.5A

$V_{ds}=1V$

$V_{ds}=50mV$

$V_{gs}(V)$

Id(A)

## FIG.5C

## FIG.6

## FIG.7

**FIG.8**

GAIN CONTROL — 4302

LINEARIZATION CIRCUIT — 3405

IF OUT — 3407

IF VGA — 3403 — 3412

SAW

DIGITAL IF SIGNAL DEMODULATION/PROCESSING — 3416 / 3414

DEMODULATED BASEBAND SIGNAL

IR REJ.

ACTIVE FILTER BANK — G / BPF

DUMMY

x/4 — DIRECT SYNTHESIS — 3402

IR REJ.

ACTIVE FILTER BANK — G / BPF — 3408

DUMMY

WB PLL — INDIRECT SYNTHESIS

OSC

WB PLL

RF — PGA LNA — 3410

RF FRONT END — 3406

CATV NETWORK